# EUROPEAN PATENT APPLICATION

(11) **EP 1 580 817 A2**
(43) Date of publication of application: **28.09.2005**
(21) Application number: 04257505.0
(22) Date of filing: 02.12.2004
(51) Int. Cl.: H01L 33/00

(54) **GaN-based compound semiconductor light emitting device and method of fabricating the same**

(30) Priority: 27.03.2004 KR 2004020993
(71) Applicant: SAMSUNG ELECTRONICS CO., LTD., Gyeonggi-do (KR); Gwangju Institute of Science and Technology, Buk-gu, Gwangju-si (KR)
(72) Inventor: Kwak, Joon-seop, 301-1101 Sinyeongtong Hyundai Apt, Hwaseong-si, Gyeonggi-do (KR); Seong, Tae-yeon, Dept. Materials Science and Eng., Buk-gu, Gwangju-si (KR); Song, June-o, Dept. Materials Science and Eng., Buk-gu, Gwangju-si (KR); Leem, Dong-swok, Dept. Materials Science and Eng., Buk-gu, Gwangju-si (KR)
(74) Representative: Greene, Simon Kenneth

(57) **Abstract**

Provided are a GaN-based III - V group compound semiconductor light emitting device and a method of fabricating the GaN-based III - V group compound semiconductor light emitting device. The GaN-based III - V group compound semiconductor light emitting device includes: at least an n-type compound semiconductor layer 12, an active layer 14, and a p-type compound semiconductor layer 16, which are disposed between an n-type electrode 30 and a p-type electrode 20. The p-type electrode 20 includes a first electrode layer 22 which is formed of Ag or an Ag-alloy on the p-type GaN-based compound semiconductor layer and a second electrode layer 24 which is formed of at least one selected from the group consisting of Ni, Ni-alloy, Zn, Zn-alloy, Cu, Cu-alloy, Ru, Ir, and Rh on the first electrode layer.

## Description

The present invention relates to a GaN-based III - V group compound semiconductor light emitting device and a method of fabricating the same, and more particularly, to a GaN-based III - V group compound semiconductor light emitting device including a p-type electrode layer having low resistance and high light transmittance.

In a light emitting diode (LED) using a Gallium nitride (GaN)-based compound semiconductor, a high-quality ohmic contact must be formed between a semiconductor layer and an electrode. An ohmic contact layer for a p-type GaN semiconductor layer may be a thin nickel (Ni)-based metal structure, i.e., a thin Ni-gold (Au) transparent metal layer (refer to U. S. Pat. No. 5,877,558 and 6,008,539).

It is known that an ohmic contact having a low non-contact resistance of about 10⁻³ to 10⁻⁴Ωcm² may be formed by annealing a thin Ni-based metal layer in an oxygen (O₂) atmosphere. According to such low non-contact resistance, a nickel oxide (NiO), which is a p-type semiconductor oxide, is formed between and on island-shaped thin Au layers at the interface between GaN and Ni during annealing in an O₂ atmosphere of 500°C to 600°C. As a result, a Schottky barrier height (SBT) is reduced. The reduction of the SBT results in easily providing major carriers, i.e., holes, in the vicinity of the surface of GaN. Thus, an effective carrier concentration increases in the vicinity of the surface of GaN. Meanwhile, after contacting Ni /Au to a p-type GaN-based semiconductor layer and then being annealed so as to remove an Mg-H complex, reactivation occurs to increase the density of Mg dopant on the surface of the p-type GaN-based semiconductor layer. As a result, an effective carrier concentration increases to more than 10¹⁹/cm³ on the surface of the p-type GaN-based semiconductor layer, and thus tunneling conduction occurs between the p-type GaN-based semiconductor layer and an electrode layer (NiO) so as to obtain ohmic conduction properties.
In a case of a thin Ni/Au layer, Au improves conductivity so as to induce low contact resistance but has relatively low light absorbance, resulting in lowering light transmittance. Accordingly, a new ohmic contact material having high light transmittance is required to realize a GaN semiconductor light emitting device having high power and high luminance.

According to an aspect of the present invention, there is provided a semiconductor light emitting device including: at least an n-type compound semiconductor layer, an active layer, and a p-type compound semiconductor layer, which are disposed between an n-type electrode and a p-type electrode. Here, the p-type electrode includes a first electrode layer which is formed of Ag or an Ag-alloy on the p-type GaN-based compound semiconductor layer and a second electrode layer which is formed of at least one selected from the group consisting of Ni, a Ni-alloy, Zn, a Zn-alloy, Cu, a Cu-alloy, Ru, Ir, and Rh on the first electrode layer.

It is preferable that the first electrode layer is formed to a thickness of 0.1 nm to 200nm.

The first and second electrode layers may be annealed in an oxygen atmosphere so that at least portion of each of the first and second electrode layers is formed to be an oxide.

According to another aspect of the present invention, there is provided a semiconductor light emitting device including: at least an n-type compound semiconductor layer, an active layer, and a p-type compound semiconductor layer, which are disposed between an n-type electrode and a p-type electrode. Here, the p-type electrode includes a first electrode layer which is formed of Ag or an Ag-alloy on the p-type GaN-based compound semiconductor layer, a second electrode which is formed of Ni or an a Ni-alloy on the first electrode layer, and a third electrode layer which is formed of at least one selected from the group consisting of Ni, a Ni-alloy, Zn, a Zn-alloy, Cu, a Cu-alloy, Ru, Ir, and Rh on the second electrode layer.

According to still another aspect of the present invention, there is provided a method of fabricating a semiconductor light emitting device, including: sequentially stacking an n-type GaN-based compound semiconductor layer, an active layer, and a p-type GaN-based compound semiconductor layer on a substrate; sequentially patterning the p-type GaN-based compound semiconductor layer and the active layer to expose a portion of the n-type GaN-based compound semiconductor layer; forming an n-type electrode on the exposed portion of the n-type GaN-based compound semiconductor layer; forming a first electrode layer of Ag or an Ag-alloy on the patterned p-type GaN-based compound semiconductor layer; forming a second electrode layer of at least one selected from the group consisting of Ni, a Ni-alloy, Zn, a Zn-alloy, Cu, a Cu-alloy, Ru, Ir, and Rh on the first electrode layer; and annealing the resultant structure in which the second electrode layer has been formed.

It is preferable that the n-type electrode and the first electrode layer are formed using e-beam evaporation or thermal evaporation.

It is preferable that the annealing is performed for 10 seconds to 2 hours at a temperature of 200 °C to 700 °C.

It is preferable that the annealing is performed under an oxygen atmosphere.

According to yet another aspect of the present invention, there is provided a method of fabricating a semiconductor light emitting device, including: sequentially stacking an n-type GaN-based compound semiconductor layer, an active layer, and a p-type GaN-based compound semiconductor layer on a substrate; sequentially patterning the p-type GaN-based compound semiconductor layer and the active layer to expose a portion of the n-type GaN-based compound semiconductor layer; forming an n-type electrode on the exposed portion of the n-type GaN-based compound semiconductor layer; forming a first electrode layer of Ag or an Ag-alloy on the patterned p-type GaN-based compound semiconductor layer; forming a second electrode layer of Ni or an Ni-alloy on the first electrode layer; forming a third electrode of at least one selected from the group consisting of Ni, a Ni-alloy, Zn, a Zn-alloy, Cu, a Cu-alloy, Ru, Ir, and Rh on the second electrode layer; and annealing the resultant structure in which the third electrode layer has been formed.

The present invention provides a semiconductor light emitting device including an ohmic contact metal system having improved light transmittance with respect to a GaN-based semiconductor layer.

The present invention also provides a method of fabricating the semiconductor light emitting device.

The above and other features and advantages of the present invention will become more apparent by describing in detail exemplary embodiments thereof with reference to the attached drawings in which:
FIG. 1 is a cross-sectional view schematically showing a GaN-based III - V group compound semiconductor light emitting device, according to an embodiment of the present invention;
FIGS. 2 through 5 are cross-sectional views showing steps of a method of fabricating the GaN-based III - V group compound semiconductor light emitting device of FIG. 1;
FIG. 6 is a graph showing a comparison between light absorbance of a p-type Ag/Ni electrode of the GaN-based III - V group compound semiconductor light emitting device of FIG. 1 and light absorbance of a conventional p-type Ni/Au electrode;
FIG. 7 is a graph showing a comparison between light transmittance of the p-type Ag/Ni electrode of the GaN-based III - V group compound semiconductor light emitting device of FIG. 1 and light transmittance of the conventional p-type Ni-Au electrode;
FIG. 8 is a graph showing electric measurement results of the p-type Ag/Ni electrode of the GaN-based III - V group compound semiconductor light emitting device of FIG. 1 which was deposited on p-type GaN to the thickness of 5nm and measured in a state of not-annealed and in a state of annealed in an air atmosphere;
FIG. 9 is a cross-sectional view schematically showing a GaN-based III - V group compound semiconductor light emitting device, according to another embodiment of the present invention;
FIG. 10 is a graph showing electric measurement results of Ag/Ni/Ru which were deposited to the thickness of 3 to 4nm and measured in a sate of not-annealed and in a state of annealed in an air atmoshpere; and
FIGS. 11 and 12 are graphs illustrating the results of Auger Electron Spectroscopy (AES) depth profiles for showing diffusion and reaction of electrode components on the interface between p-type GaN and Ag/Ni/Ru which were deposited on the p-type GaN and measured in a state of not-annealed and in a state of annealed in an oxygen atmosphere.

Hereinafter, a GaN-based III - V group compound semiconductor light emitting device, according to a preferred embodiment of the present invention, and a method of fabricating the GaN-based III - V group compound semiconductor light emitting device will be described in detail with reference to the attached drawings. In the drawings, the thicknesses of layers and regions are exaggerated for clarity.

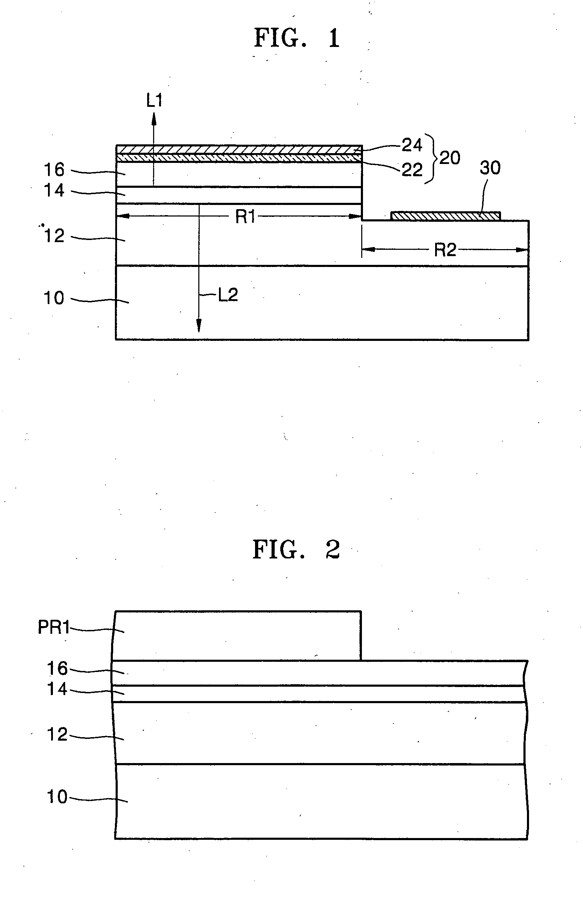

FIG. 1 is a cross-sectional view schematically showing a GaN-based III - V group compound semiconductor light emitting device, according to an embodiment of the present invention. Referring to FIG. 1, a first compound semiconductor layer 12 is formed on a transparent substrate 10. The first compound semiconductor layer 12 is preferably an n-type III - V group compound semiconductor layer, for example, an n-GaN layer, but may be another type of compound semiconductor layer. The first compound semiconductor layer 12 may be divided into first and second regions R1 and R2. An active layer 14, which emits light, for example, blue or green light through a recombination of p-type and n-type carriers, is stacked on the first region R1. A second compound semiconductor layer 16 is stacked on the active layer 14. The second compound semiconductor layer 16 is preferably a p-type III - V group compound semiconductor layer, for example, a p-GaN layer, but may be another type of compound semiconductor layer.

A p-type electrode 20, which is a characteristic part of the present invention, is formed on the second compound semiconductor layer 16. The p-type electrode 20 includes a first electrode layer 22 which is formed of Ag or an Ag-alloy and a second electrode layer 24 which is formed on the first electrode layer 22. The second electrode layer 24 is formed of at least one of Ni, a Ni-alloy, Zn, a Zn-alloy, Cu, a Cu-alloy, Ru, Ir, and Rh.

Each of the first and second electrode layers 22 and 24 may be formed to the thickness of 0.1 nm to 200nm, preferably, to the thickness of about 5nm.

It is preferable that the transparent substrate 10 is formed of sapphire.

Meanwhile, an n-type electrode 30 is formed on the second region R2 of the first compound semiconductor layer 12.

The first and second electrode layers 22 and 24 may be annealed in an oxygen atmosphere, and thus at least portion of each of them may be changed into an oxide.

When a voltage greater than a threshold voltage necessary for light emission is applied to the p-type and n-type electrodes 20 and 30, the active layer 14 emits light. A portion of the light L1 emitted from the active layer 14 passes through the p-type electrode 20, and a portion of the light L2 passes through the transparent substrate 10, is reflected from a plate (not shown) disposed underneath the transparent substrate 10, and advances toward the p-type electrode 20.

A method of fabricating the GaN-based III - V group compound semiconductor light emitting device of FIG. 1 will now be described in detail with reference to FIGS. 2 through 5.

Referring to FIG. 2, the first compound semiconductor layer 12 is formed on the transparent substrate 10 which is formed of sapphire. The first compound semiconductor layer 12 is preferably an n-type GaN layer but may be another type of compound semiconductor layer. The active layer 14 and the second compound semiconductor layer 16 are sequentially formed on the first compound semiconductor layer 12. The second compound semiconductor layer 16 is preferably a p-type GaN layer but may be another type of compound semiconductor layer. A first photoresist layer pattern PR1 is formed on the second compound semiconductor layer 16. The first photoresist layer pattern PR1 defines regions in which the p-type and n-type electrodes 20 and 30 are to be formed.

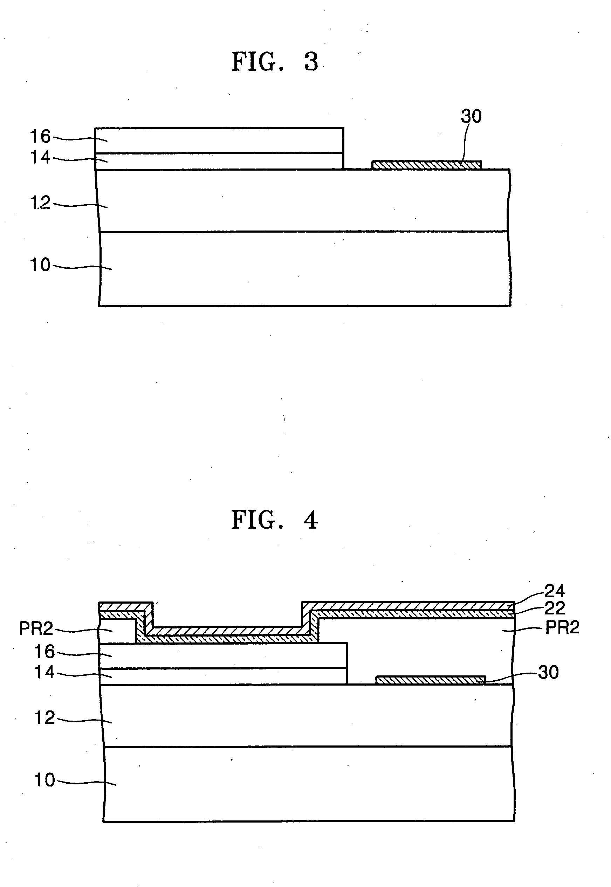

Referring to FIGS. 2 and 3, the second compound semiconductor layer 16 and the active layer 14 are sequentially etched using the first photoresist layer pattern PR1 as an etch mask. Here, etching is preferably performed until the first compound semiconductor layer 12 is exposed but may be performed until a portion of the first compound semiconductor layer 12 is removed. Thereafter, the first photoresist layer pattern PR1 is removed. The n-type electrode 30 is formed on a predetermined region of the first compound semiconductor layer 12 which has been exposed by etching. The n-type electrode 30 may be formed after subsequent processes, which will be explained later.

Referring to FIG. 4, a second photoresist layer pattern PR2 is formed on the resultant structure in which the n-type electrode 30 has been formed so as to cover the n-type electrode 30 and to expose an upper surface of the second compound semiconductor layer 16. The second photorsist layer pattern PR2 defines a region in which the p-type electrode 30 is to be formed. The first metal layer 22 is formed on the second photoresist layer pattern PR2 using e-beam evaporation or thermal evaporation so as to contact the exposed upper surface of the second compound semiconductor layer 16. The first metal layer 22 is formed of Ag or an Ag-alloy. Also, the first metal layer 22 may be formed to the thickness of 0.1 nm to 200nm but preferably, to the thickness of about 5nm.

The second metal layer 24 is formed on the first metal layer 22 using e-beam evaporation or thermal evaporation. The second metal layer 24 is formed of at least one of Ni, a Ni-alloy, Zn, a Zn-alloy, Cu, a Cu-alloy, Ru, Ir, and Rh. The second metal layer 24 may be formed to the thickness of 0.1 nm to 200nm but preferably, to the thickness of about 5nm.

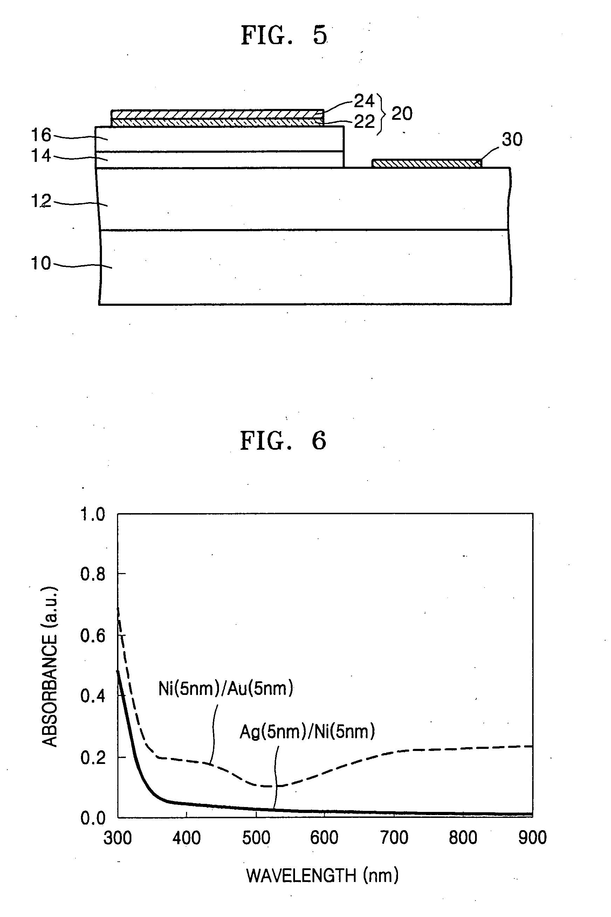

The second photoresist layer pattern PR2 is then lifted off. Here, the first and second metal layers 22 and 24 on the second photoresist layer pattern PR2 are also removed. As a result, as shown in FIG. 5, the first and second metal layers 22 and 24 are formed on the second compound semiconductor layer 16 to be used as the p-type electrode 20.

Thereafter, the resultant structure in which patterning has been completed is annealed for 10 seconds to 2 hours at a temperature of 200 °C to 700 °C in an air or oxygen atmosphere. As a result, the p-type electrode 20 is formed on the surface of the p-type compound semiconductor layer 16 so as to form an ohmic contact with the p-type compound semiconductor layer 16.

In the meantime, the n-type electrode 30 may be formed after the second photoresist layer pattern PR2 is removed.

FIG. 6 is a graph showing a comparison between light absorbance of a p-type Ag/Ni electrode of the present invention and light absorbance of a conventional p-type Ni/Au electrode. Each of the p-type Ag/Ni electrode of the present invention and the conventional p-type Ni/Au electrode includes two layers, each of which is deposited to the thickness of 5nm. The p-type Ag/Ni electrode of the present invention and the conventional p-type Ni/Au electrode were annealed for one minute at a temperature of 550 °C in an air atmosphere to compare their characteristics. As can be seen in FIG. 6, the light absorbance of the p-type Ag/Ni electrode of the present invention is remarkably lower than the light absorbance of the conventional p-type Ni/Au electrode at the wavelength of 400nm to 800nm.

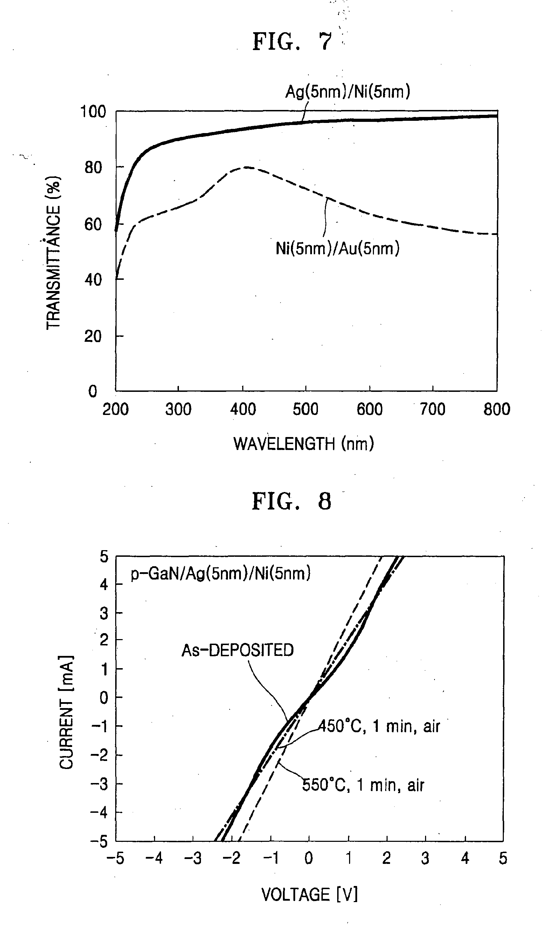

FIG. 7 is a graph showing a comparison between light transmittance of the p-type Ag/Ni electrode of the present invention and light transmittance of the conventional p-type Ni/Au electrode. Each of the p-type Ag/Ni electrode of the present invention and the conventional p-type Ni/Au electrode includes two layers, each of which is deposited to the thickness of 5nm. The p-type Ag/Ni electrode of the present invention and the conventional p-type Ni/Au electrode were annealed for one minute at a temperature of 550 °C in an air atmosphere to compare their characteristics. As can be seen in FIG. 7, the p-type Ag/Ni electrode shows high light transmittance of more than 90% at the wavelength of 300nm to 800 nm. At the wavelength of 460nm, the p-type Ag/Ni electrode shows much higher transmittance than the conventional p-type Ni/Au electrode. In other words, the p-type Ag/Ni electrode and the conventional p-type Ni/Au electrode show light transmittances of 94% and 76%, respectively.

FIG. 8 is a graph showing electric measurement results of Ag and Ni which were deposited on p-type GaN having carriers of 4 to 5 x 10²²/cm3 to the thickness of 5nm and annealed in an air atmosphere. As can be seen in FIG. 8, ohmic properties of current (I)-voltage (V) characteristics of Ag/Ni, which are annealed for one minute at temperatures of 450°C and 550°C, respectively, are better than those of I-V characteristics of not-annealed (as deposited) Ag/Ni. This is because a portion of each of Ag and Ni is changed into an oxide during annealing, resulting in lowering resistance.

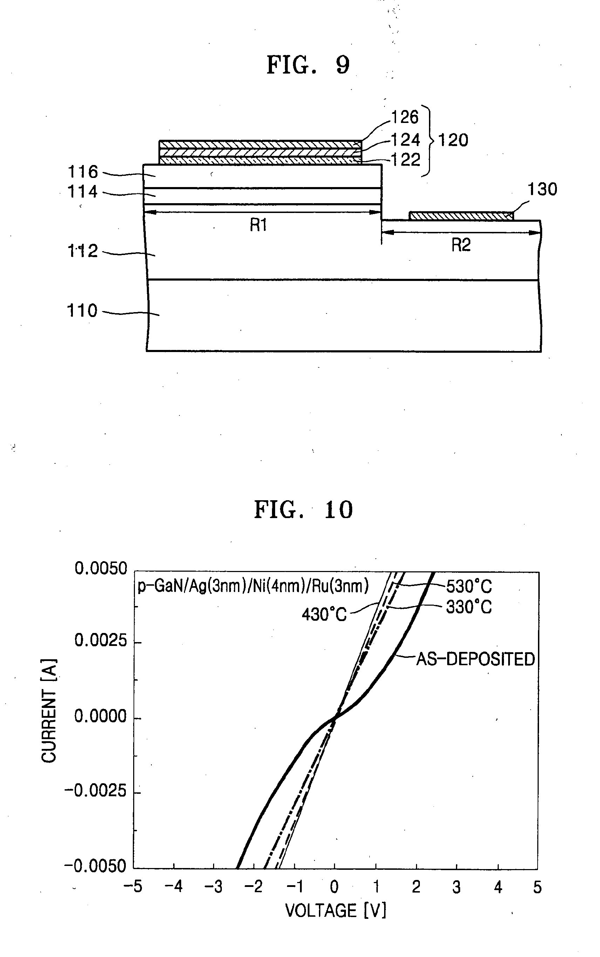

FIG. 9 is a cross-sectional view schematically showing a GaN-based III - V group compound semiconductor light emitting device, according to another embodiment of the present invention. Referring to FIG. 9, an n-GaN layer 112 is formed on a transparent substrate 110. The n-GaN layer 112 is divided into first and second regions R1 and R2. An active layer 114 and a p-GaN layer 116 are sequentially stacked on the first region R1 of the n-GaN layer 120.

A p-type electrode 120, which is a characteristic part of the present invention, is formed on the p-GaN layer 116. The p-type electrode 120 includes a first electrode layer 122 which is formed of Ag or an Ag-alloy, a second electrode layer 124 which is formed on the first electrode layer 122, and a third electrode 126 which is formed on the second electrode layer 124. The second electrode layer 124 is formed of Ni or a Ni-alloy. The third electrode layer 126 is formed of at least one of Ni, a Ni-alloy, Zn, a Zn-alloy, Cu, a Cu-alloy, Ru, Ir, and Rh.

Each of the first, second, and third electrode layers 122, 124, and 126 may be formed to the thickness of 0.1 nm to 200nm, preferably, to the thickness of 5nm.

It is preferable that the transparent substrate 110 is formed of sapphire.

An n-type electrode 130 is formed on the second region R2 of the n-GaN layer 112.

A method of fabricating the GaN-based III - V group compound semiconductor light emitting device of FIG. 9 will now be explained with reference to the method of fabricating the GaN-based III - V group compound semiconductor light emitting device according to the first embodiment of the present invention and FIG. 9.

Processes of forming the n-GaN layer 112, the active layer 114, and the p-GaN layer 116, sequentially etching the p-GaN layer 116, the active layer 114, and the n-GaN layer 112, forming the n-type electrode 130 on the second region R2 of the n-GaN layer 112, and forming the second photoresit layer pattern PR2 in FIG. 4 and the first metal layer 122 are the same as those of the first embodiment.

The second and third metal layers 124, and 126 are sequentially stacked on the first metal layer 122. Here, the second metal layer 124 is formed of Ni or a Ni-alloy, and the third electrode layer 126 is formed of at least one of Ni, a Ni-alloy, Zn, a Zn-alloy, Cu, a Cu-alloy, Ru, Ir, and Rh.

Thereafter, the second photoresist layer pattern PR2 is removed. Here, the first, second, and third metal layers 122, 124, and 126 on the second photoresist layer pattern PR2 are also removed. Thus, as shown in FIG. 9, the first, second, and third metal layers 122, 124, and 126 are formed on the p-GaN layer 116 to be used as the p-type electrode 120.

Next, the resultant structure in which patterning has been completed is annealed for 10 seconds to 2 hours at a temperature of 200 °C to 700 °C in an air atmosphere to form the p-type electrode 120 on the surface of the p-Gan layer 116 using the formation of an ohmic contact.

FIG. 10 is a graph showing electric measurement results of Ag/Ni/Ru which were deposited on p-type GaN having carriers of 4 to 5 x 10²²/cm³ to the thickness of 3 to 4 nm and measured in a state of not-annealed (as-deposited) and in a state of annealed in an air atmosphere. As can be seen in FIG. 10, ohmic properties of I-V characteristics of Ag/Ni/Ru, which are annealed for one minute at temperatures of 330 °C, 450 °C, and 550 °C, respectively, are much better than those of I-V characteristics of not-annealed (as deposited) Ag/Ni/Ru.

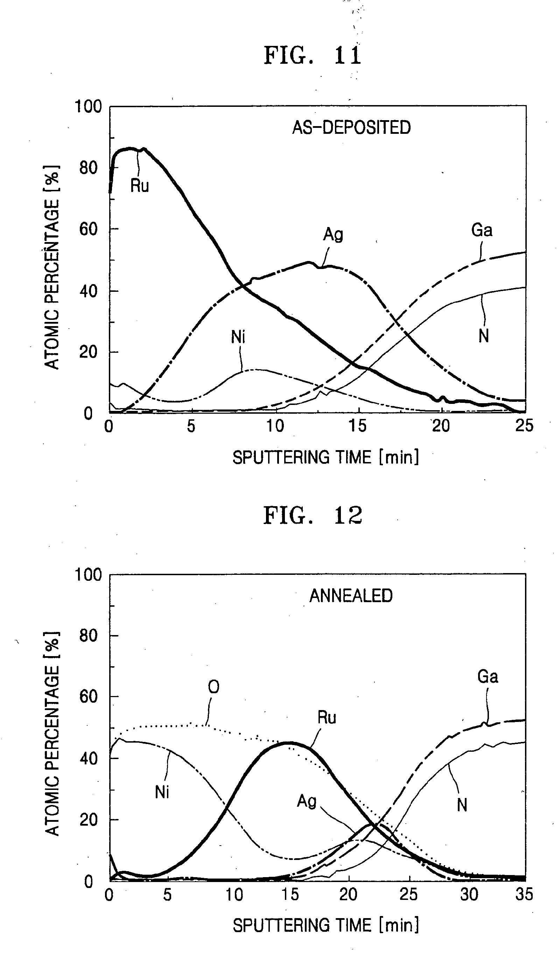

FIGS. 11 and 12 are graphs illustrating the results of AES depth profiles showing diffusion and reaction of electrode components on the interface between p-type GaN and Ag/Ni/Ru which were deposited on the p-type GaN and measured in a state of not-annealed (as-deposited) and in a state of annealed in an oxygen atmosphere.

Referring to FIG. 11, as the depth of a p-type electrode increases, Ru decreases while Ni and Ag increase and then decrease. When sputtering time gets longer, p-type GaN components appear.

Referring to FIG. 12, Ru and Ni are oxidized during annealing, and thus their positions are reversed. Thus, Ni oxide and Ru oxide are formed from the surface of the p-type electrode. A portion of Ag is also oxidized. Theses oxides serve to improve light transmittance.

As described above, in a GaN-based III - V group compound semiconductor light emitting device according to the present invention, a p-type electrode shows an improved light transmittance although having a low resistance like a conventional Ni/Au electrode. Also, high-quality ohmic contact properties can be obtained.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A light emitting device comprising:
an n-type compound semiconductor layer, an active layer, and a p-type compound semiconductor layer, which are disposed between an n-type electrode and a p-type electrode,
wherein the p-type electrode comprises a first electrode layer which is formed of Ag or an Ag-alloy on the p-type GaN-based compound semiconductor layer and a second electrode layer which is formed of at least one selected from the group consisting of Ni, a Ni-alloy, Zn, a Zn-alloy, Cu, a Cu-alloy, Ru, Ir, and Rh on the first electrode layer.

2. The light emitting device of claim 1, wherein the first electrode layer is formed to a thickness of 0.1 nm to 200nm.

3. The light emitting device of claim 1, wherein the first and second electrode layers are annealed in an oxygen atmosphere so that at least portion of each of the first and second electrode layers is formed to be an oxide.

4. A light emitting device according to claim 1 or 2 comprising:
wherein the p-type electrode comprises a second electrode which is formed of Ni or a Ni-alloy on the first electrode layer, and a third electrode layer which is formed of at least one selected from the group consisting of Ni, a Ni-alloy, Zn, a Zn-alloy, Cu, a Cu-alloy, Ru, Ir, and Rh on the second electrode layer.

5. The semiconductor light emitting device of claim 4, wherein the first, second, and third electrode layers are annealed in an oxygen atmosphere so that at least portion of each of the first, second, and third electrode layers is formed to be an oxide.

6. A method of fabricating a semiconductor light emitting device, comprising:
sequentially stacking an n-type GaN-based compound semiconductor layer, an active layer, and a p-type GaN-based compound semiconductor layer on a substrate;
sequentially patterning the p-type GaN-based compound semiconductor layer and the active layer to expose a portion of the n-type GaN-based compound semiconductor layer;
forming an n-type electrode on the exposed portion of the n-type GaN-based compound semiconductor layer;
forming a first electrode layer of Ag or an Ag-alloy on the patterned p-type GaN-based compound semiconductor layer;
forming an electrode layer of at least one selected from the group consisting of Ni, a Ni-alloy, Zn, a Zn-alloy, Cu, a Cu-alloy, Ru, Ir, and Rh on the first electrode layer; and
annealing the resultant structure in which the electrode layer has been formed.

7. The method of claim 6, wherein the first electrode layer is formed to a thickness of 0.1 nm to 200nm.

8. The method of claim 6 or 7, wherein the n-type electrode and the first electrode layer are formed using e-beam evaporation or thermal evaporation.

9. The method of claim 6, 7 or 8, wherein the annealing is performed for 10 seconds to 2 hours at a temperature of 200 °C to 700 °C.

10. The method of claim 9, wherein the annealing is performed under an oxygen atmosphere.

11. A method of fabricating a semiconductor light emitting device according to claims 6, 7, 9 or 10, comprising:
forming a second electrode layer of Ni or a Ni-alloy on the first electrode layer;
forming a third electrode of at least one selected from the group consisting of Ni, a Ni-alloy, Zn, a Zn-alloy, Cu, a Cu-alloy, Ru, Ir, and Rh on the second electrode layer; and
annealing the resultant structure in which the third electrode layer has been formed.

12. The method of claim 11, wherein the n-type electrode and the first and second electrode layers are formed using e-beam evaporation or thermal evaporation.
